# EUROPEAN PATENT APPLICATION

(11) **EP 1 113 490 A2**
(43) Date of publication of application: **04.07.2001**
(21) Application number: 00128590.7
(22) Date of filing: 27.12.2000
(51) Int. Cl.: H01L 21/56

(54) **Resin sealing method for semiconductors and release film used therefor**

(30) Priority: 27.12.1999 JP 36959399; 29.03.2000 JP 2000090039
(71) Applicant: NITTO DENKO CORPORATION, Osaka (JP)
(72) Inventor: Tachibana, Toshimitsu, c/oNitto Denko Corporation, Ibaraki-shi, Osaka (JP); Takano, Hitoshi, c/oNitto Denko Corporation, Ibaraki-shi, Osaka (JP); Nabata, Norikane, c/oNitto Denko Corporation, Ibaraki-shi, Osaka (JP)
(74) Representative: Grünecker, Kinkeldey, Stockmair & Schwanhäusser Anwaltssozietät

(57) **Abstract**

A resin sealing method for semiconductors comprises molding a resin with a release film 1 interposed between a molding die 4 and a sealing surface of a semiconductor chip 2 having terminals 22 or electrodes in such a manner that the sealed semiconductor chip may have the tips of the terminals 22 or the electrodes exposed on the surface of the cured resin which has been in contact with the release film 1, wherein the release film 1 is a composite film comprising a base layer 11 and an auxiliary layer 12 having a lower compressive modulus than the base layer 11, and the release film is used with the auxiliary layer 12 facing the sealing surface of the semiconductor chip 2.

## Description

### Background of the Invention

### 1. Field of the Invention

This invention relates to a method of sealing semiconductor chips with a resin and a release film used therefor. The invention is applicable to quad flat non-leaded (QFN) packages or small outline-leaded (SON) packages.

### 2. Description of the Related Art

With the spread of chip scale packages (CSPs) of resin-sealed semiconductor devices, reduction of the sealing resin has been promoted. It has been demanded accordingly to reduce or eliminate a releasing agent to be added to the resin so as to secure strong adhesion at the sealing interface even with a reduced amount of the sealing resin.

In order to secure releasability of a cured resin from the molding die with no or little use of a releasing agent, it has been practiced to use a release film between the sealing surface of a semiconductor chip and a molding die. JP-A-8-197567 and JP-A-8-186141 propose using a fluoroplastic film, such as a polytatrafluoroethylene film, a tetrafluoroethylene-ethylene copolymer film or a betrafluoroethylene-hexafluoropropylene copolymer film, as a release film having heat resistance against a mold temperature of about 150 to 200°C.

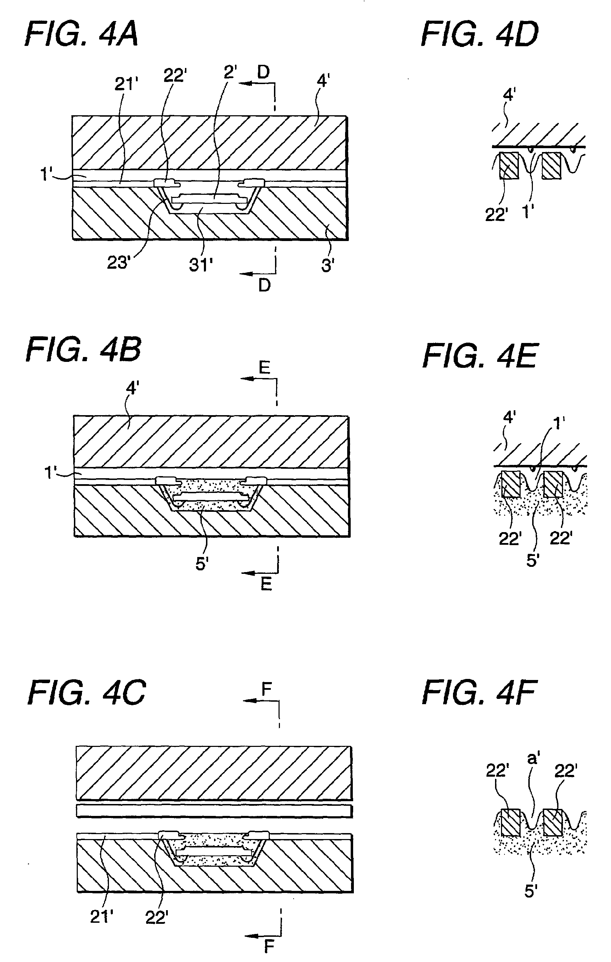

Figs. 4A to 4F show a method of manufacturing QFN packages by use of the above-described release film of the related art. As shown in Fig. 4A, a semiconductor chip 2' whose surface electrodes are bonded with wires 23' to the terminals 22' of a lead frame 21' is placed in the cavity 31' of a cavity block 3' with the terminals 22' up, and the cavity is closed by an upper block 4' with a release film 1' interposed between the sealing surface of the chip and the upper block. A resin 5' is transferred into the cavity 31' and cured by transfer molding (Fig. 4B). The molding die is opened (Fig. 4C), and the lead frame 21' is trimmed, leaving the,terminals 22' on the package.

However, the present inventors' investigation has revealed that the above-described fluoroplastic film has the following disadvantage in the QFN packaging. As shown in Fig. 4D, which is a cross section taken along line D-D in Fig. 4A, the release film 1', being compressed between the upper block 4' and the terminals 22', flows laterally and protrudes downward between the terminals 22'. It tends to follow that the resin 5' fails to completely fill the space between the terminals 22' (Fig. 4E, a cross section along line E-E in Fig. 4B), resulting in formation of resin-starved areas a' (Fig. 4F, a cross section alone line F-F in Fig. 4C) where the terminal fixing strength is insufficient. As a result, it is often observed that the terminals fall off or the resin which should have filled the space among the terminals comes off (resin missing) when the terminals are cut off the lead frame.

In order to prevent the release film from flowing laterally and protruding downward between the terminals when compressed, the inventors have tried a release film having a high compressive modulus, such as a polyimide film. As a result, non filling between the terminals could be avoided, but it turned out that the release film tends to allow the molten resin to flow into the contact interface with the terminals to form a flash covering the terminals. This seems ascribed to too high a compressive modulus of the release film.

In this way, the release film to be used in resin sealing for the manufacture of QFN packages, etc. is required to satisfy requirements conflicting with each other, i.e., a high elastic modulus or a high hardness and a low compressive modulus or softness. It has been difficult with the release films of the related art, which are one layer films, to accomplish satisfactory resin sealing in QFN packaging, etc.

### Summary of the Invention

An object of the present invention is to provide a method of resin sealing semiconductors with a release film in good yield and with ease and a release film used therefor.

The invention provides a resin sealing method for semiconductors which comprises molding a resin with a release film interposed between a molding die and a sealing surface of a semiconductor chip having terminals or electrodes in such a manner that the sealed semiconductor chip may have the tips of the terminals or electrodes thereof exposed on the surface of the cured resin which has been in contact with the release film, wherein the release film is a composite film comprising a base layer and an auxiliary layer having a lower compressive modulus than the base layer, and the release film is used with the auxiliary layer thereof facing the sealing surface of the semiconductor chip.

The invention also provides a release film used in the above-mentioned resin sealing method which is a composite film comprising a base layer and an auxiliary layer having a lower compressive modulus than the base layer.

In a highly preferred embodiment of the invention, the base layer of the composite film has a compressive modulus of 50 MPa or higher at 175°C and/or the auxiliary layer of the composite film comprises a fluororesin or a fluororubber. The fluororubber auxiliary layer can have a thin fluororesin film on the surface thereof.

### Brief Description of the Drawings

Fig. 1 shows a release film according to the invention.
Fig. 2 shows an embodiment of the semiconductor resin sealing method according to the invention.
Fig. 3 illustrates a lead frame.
Fig, 4 shows a method of sealing semiconductor chips in a resin of the related art.

### Detailed Description of the Invention

The practice of the present invention will be described with reference to the accompanying drawings.

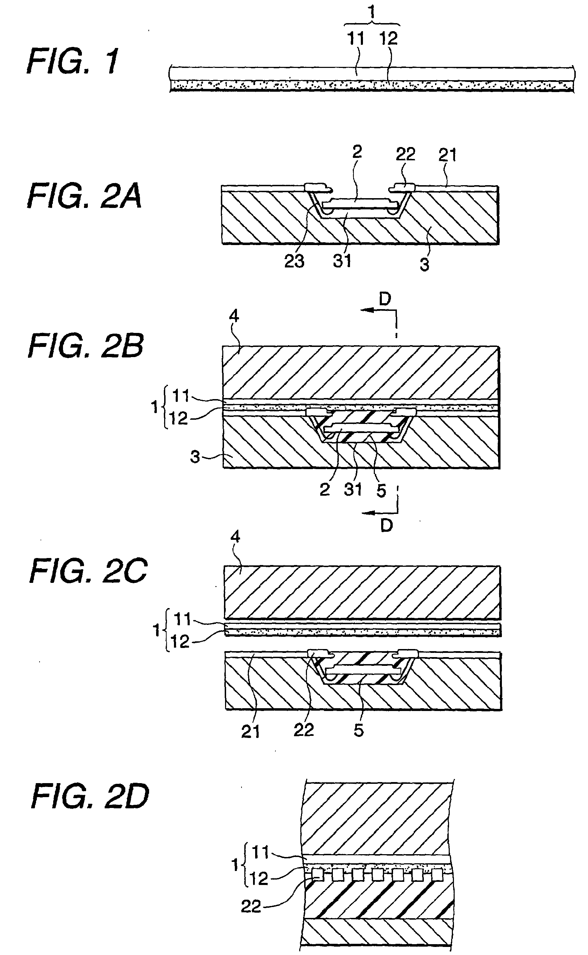

Fig. 1 shows a release film 1 for semiconductor resin sealing according to the invention, which is comprising a base layer 11 and an auxiliary layer 12 having a lower compressive modulus than the base layer 11.

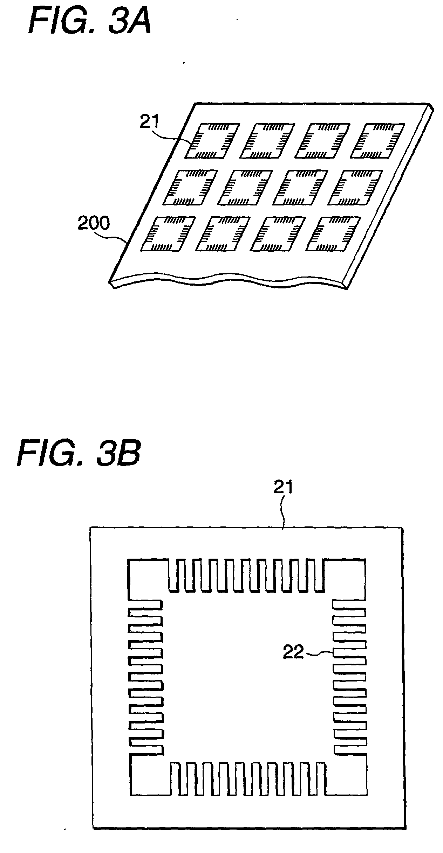

Figs. 2A to 2D show an embodiment of the semiconductor resin sealing method according to the invention. The object to be sealed is semiconductor chips 2, of which the surface electrodes are bonded with wires 23 (see Fig. 2A) to inner terminals 22 of each unit 21 (see Fig. 3B) of a lead frame 2000 shown in Fig. 3A. For the sake of simplicity, Figs. 2A to 2D illustrate one unit 21 of the lead frame 2000.

As shown in Fig. 2A, the semiconductor chip 2 is put in the cavity 31 of a heated cavity block (lower block) 3 of a transfer molding die with the inner terminals 22 up. The lower block 3 is closed by an upper block 4 via the release film 1 of Fig. 1 interposed therebetween with the auxiliary layer 12 facing down (see Fig. 28). A resin 5 is transferred into the cavity 31 and cured. The upper block 4 is lifted to open the molding die while the release film 1 is released from the cured resin 5 (see Fig. 2C). The lead frame 21 is then trimmed leaving the terminals 22 to obtain a QFN package.

Fig. 2D is a cross section taken along line D-D in Fig. 2B. Having a low compressive modulus, the auxiliary layer 12 tightly fits in with an uneven surface thereby preventing the molten resin from penetrating into the contact interface with the terminals 22 and covering the terminals 22.

Because the base layer 11 has a high compressive modulus, it has only a small compression strain and hardly flows laterally even under the mold clamping force. The auxiliary layer 12, which is likely to flow laterally, is blocked by the base layer 11 integral with the auxiliary layer 12 so that the thickness of the release film among the terminals 22 can be maintained substantially at the initial one. As a result, the space among the terminals can be filled with a sufficient amount of the resin, in which the terminals 22 are embedded firmly.

Accordingly, when the lead frame is trimmed, fall-off of the terminals and resin missing among the terminals can be prevented with certainty to provide QFN packages in a satisfactory yield.

The base layer 11 should be such as to be substantially prevented from compression deformation under the mold clamping force and at the mold temperature. Specifically, it is preferred for the base layer 11 to have a compressive modulus of 40 MPa or higher, more preferably 50 MPa or higher at 175°C. Examples of suitable base layers include plastic films of polyimide, aramid, polyether ketone, polyether sulfone, etc-and metal foils of copper, stainless steel, aluminum, etc.

The thickness of the base layer 11 is not limited, but is preferably 500 µm or less, more preferably 5 to 50 µm, in view of handling, etc.

The auxiliary layer 12 should be such as to have a low compressive modulus under the mold clamping force and at the mold temperature to assure excellent sealing properties for the terminals. Specifically, it is desirable for the auxiliary layer 12 to have a compressive modulus of less than 40 MPa, perferably 30 MPa or lower, particularly 20 MPa or lower, at 175°C. Examples of suitable auxiliary layers include fluororesins, such as polytetrafluoroethylene, tetrafluoroethylene-perfluoroalkyl vinyl ether copolymers, tetrafluoroethylene-hexafluoropropylene copolymers, polyvinylidene fluoride, and fluororubbers. The most suitable of them is polytetrafluoroethylene for its excellent release properties.

If desired, the auxiliary layer made of a fluororubber can have formed thereon a thin fluororesin film of polytetrafluoroethylene, a tetrafluoroethylene-hexafluoropropylene copolymer, polyvinylidene fluoride, etc. to have improved release properties.

The thickness of the auxiliary layer 12 should be as thin as is consistent with close fitting properties for the terminals. It is usually 5 to 50 µm, preferably 10 to 30 µm. A smaller thickness than 5 µm hardly assures fitting properties, and a larger thickness than 50 µm hardly secures a prescribed space to be filled with a resin among the terminals.

As far as the above-described relationship in compressive modulus, the base layer and the auxiliary layer may be of a kind in material. In this case, the compressive modulus of the two layers can be adjusted appropriately by controlling at least one of molecular weight, crystallinity, porosity, orientation, and stretch properties.

The composite film of the invention can be prepared usually by wet or dry lamination, coating, extrusion lamination, and the like.

The resin sealing method of the invention is applied to semiconductor packages in which lead terminals are embedded while having the upper surface thereof exposed on the surface of the sealing resin. Therefore, the invention is applicable to not only the above-described QFN packages but other CSPs, such as those to be flip chip bonded having the terminals thereof to be brought into contact with external terminals (e.g., solder balls) exposed on the sealing resin surface, and packages by wafer level processing.

The present invention will now be illustrated in greater detail with reference to Examples, but it should be understood that the invention is not limited thereto- Unless otherwise noted, all the percents are given by weight.

### EXAMPLE 1

A 50 µm thick polyimide (PI) film was used as a base layer. A 50% aqueous dispersion of tetrafluoroethylene powder was applied to the PI film, dried at 90°C for 2 minutes to evaporate water, and baked at 360°C for 2 minutes. The same operation was repeated once more to form a polytetrafluoroethylene (PTEF) auxiliary layer having a thickness of 25 µm. The resulting composite film (release film) had a total thickness of 75 µm.

### EXAMPLE 2

A release film having a total thickness of 75 µm was prepared in the same manner as in Example 1, except for using a 50 µm thick aluminum (Al) foil as a base layer.

### EXAMPLE 3

An aqueous solution containing 50% of a fluororubber powder comprising a vinylidene fluoride unit in a major proportion and hexafluoropropylene unit in a minor proportion and 5% of a polyamine curing agent was applied to a 50 µm thick PI film as a base layer, dried at 90°C for 2 minutes to evaporate water, and baked at 300°C for 10 minutes. The same operation was repeated once more to form a fluororubber auxiliary layer having a thickness of 25 µm. The resulting release film had a total thickness of 75 µm.

### EXAMPLE 4

A release film comprising a 50 µm thick PI film as a base layer and a 7 µm thick fluororubber auxiliary layer was prepared in the same manner as in Example 3, except that the operation of applying the coating solution and baking was conducted only once. The resulting release film had a total thickness of 57 µm.

### EXAMPLE 5

A release film comprising a 50 µm thick PI film as a base layer and a 47 µm thick fluororubber auxiliary layer was prepared in the same manner as in Example 3, except that the operation of applying the coating solution and baking was conducted four times. The resulting release film had a total thickness of 97 µm.

### EXAMPLE 6

A release film comprising a 50 µm thick PI film as a base layer and a 25 µm thick fluororubber auxiliary layer was prepared in the same manner as in Example 3. A 20% aqueous dispersion of a tetrafluoroethylene-hexafluoropropylene copolymer (FEP) powder was applied to the fluororubber auxiliary layer of the release film, dried at 90°C for 2 minutes to remove water, and baked at 360°C for 2 minutes to form a thin FEP film having a thickness of 1 µm. The resulting release film had a total thickness of 76 µm.

### COMPARATIVE EXAMPLE 1

An aqueous dispersion containing 50% of a tetrafluoroethylene powder was applied to a 100 µm thick PI sheet, dried at 90°C for 2 minutes to evaporate water, and baked at 360°C for 2 minutes. The same operation was repeated four times in all. The PI sheet was stripped off to obtain a 50 µm thick polytetrafluoroethylene (PTFE) film as a release film.

### COMPARATIVE EXAMPLE 2

A 50 µm thick PI film was used as a release film.

A 5 mm by 5 mm square was cut out of each of the release films prepared in Examples 1 to 6 and Comparative Examples 1 and 2. The auxiliary layer was peeled off the cut piece of Examples. The modulus in 10% compression of the test piece (a one layer release film or a base layer) was measured at 175°C with a viscoelasticity spectrometer by a penetration method under conditions of a needle diameter of 0.5 mm and a loading rate of 50 gf/min. The results obtained are shown in Table 1 below.

Semiconductor chips were resin-sealed by transfer molding using the release films prepared in Examples and Comparative Examples as shown in Figs. 2A to 2C. The transfer molding was carried out at a mold temperature of 175°C 50 kg/cm² for a molding time of 120 seconds. After curing, the upper block was lifted together with the release film whereby the packages were released from the release film by their own weight. Fifty packages sampled were inspected for the resin's covering the terminals. Further, after post cure and lead frame cutting, the fifty packages were inspected for resin missing. The results of the inspections are shown in Table 1.

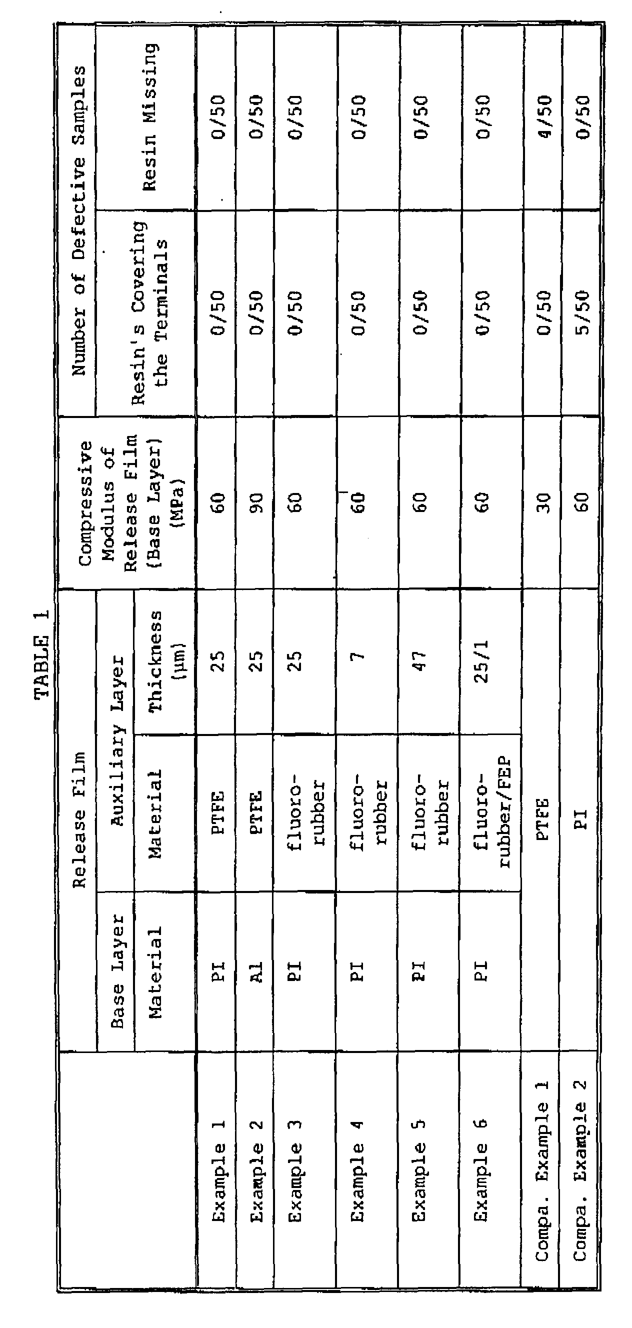

As is apparent from Table 1, the release films of Examples enable satisfactory resin sealing in packaging semiconductor chips.

It is apparent, to the contrary, that the release film of Comparative Example 1 fails to completely avoid resin missing between the terminals, which is the result of resin starvation between the terminals due to the downward protrusion of the release film between the terminals because of the low compressive modulus of the release film. In Comparative Example 2, the release film fails to completely get rid of the resin's covering the terminals. This is the result of the release film failing to fit the terminals because of its high compressive modulus.

That is, both resin missing and resin's covering the terminals can be prevented in the present invention by combining a base layer having a high compressive modulus and an auxiliary layer having a low compressive modulus. It was confirmed that the release film of Example 6 exhibits particularly excellent release properties owing to the tetrafluoroethylene-hexafluoropropylene copolymer thin film provided on its surface, achieving smooth release of packages by their own weight.

According to the present invention, in packaging semiconductor chips while leaving the upper surface of the terminals or electrodes exposed by resin sealing using a release film, the chips can be sealed in a resin in high yield without suffering from resin's covering the terminals or electrodes or resin missing among the terminals which have been often observed with release films of the related art. This effect leads to reduction or elimination of a release agent from a sealing resin, which will bring about improvement in sealing performance of the sealing resin and further reduction of package size. Therefore, the invention gives an advantage to the chip size packaging technology. Additionally, the invention makes it possible to reduce the mold cleaning frequency, which will lead to improved working efficiency and an extended life of the mold (i.e., cost reduction), and also to omit ejection pins, which means simplification of the mold structure.

## Claims

1. A resin sealing method for semiconductors, which comprises molding a resin with a release film interposed between a molding die and a sealing surface of a semiconductor chip having terminals or electrodes in such a manner that the sealed semiconductor chip may have the tips of said terminals or electrodes exposed on the surface of the cured resin which has been in contact with the release film, wherein said release film is a composite film comprising a base layer and an auxiliary layer having a lower compressive modulus than the base layer, and the release film is used with said auxiliary layer facing the sealing surface of the semiconductor chip.

2. A release film used in resin sealing of semiconductor chips which is a composite film comprising a base layer and an auxiliary layer having a lower compressive modulus than the base layer, and the release film is used with said auxiliary layer facing the sealing surface of semiconductor chips.

3. The release film according to claim 2, wherein said base layer has a compressive modulus of 50 MPa or more at 175°C.

4. The release film according to claim 2, wherein said auxiliary layer comprises a fluororesin.

5. The release film according to claim 2, wherein said auxiliary layer comprises a fluororubber.

6. The release film according to claim 2, wherein said auxiliary layer has a thin fluororesin film on the surface thereof.

7. The release film according to claim 2, wherein said auxiliary layer has a compressive modulus of 30 Mpa or less at 175°C.

8. The release film according to claim 2, wherein said auxiliary layer has a thickness of 5 to 50 µm.
